# EUROPÄISCHE PATENTANMELDUNG

(11) **EP 2 980 995 A1**
(43) Veröffentlichungstag der Anmeldung: **03.02.2016**
(21) Anmeldenummer: 14178962.8
(22) Anmeldetag: 29.07.2014
(51) Int. Cl.: H03M 7/30, H03M 7/40, H03M 13/00, G05B 19/05, G05B 19/042

(54) **Automatisierungsgerät**

(71) Anmelder: Siemens Aktiengesellschaft, 80333 München (DE)
(72) Erfinder: Glaser, Martin, 76698 Ubstadt-Weiher (DE); Lutz, Benjamin, 76327 Pfinztal (DE)

(57) **Zusammenfassung**

Die Erfindung betrifft ein Automatisierungsgerät mit einem ersten Funktionsbaustein (2) zur Erzeugung von Prozessdaten (6) für einen Aktuator oder zum Empfang von Prozessdaten eines Sensors und mit einem diesem ersten Funktionsbaustein (2) nachgeschalteten zweiten Funktionsbaustein (3), welcher dazu ausgebildet ist, Prozessdaten (6) mit einem Zeitstempel (7) zu versehen. Es werden Maßnahmen vorgeschlagen, mittels welcher im Automatisierungsgerät (1) Prozessdaten (6) für eine Archivierung aufbereitet werden können.

## Beschreibung

Die Erfindung betrifft ein Automatisierungsgerät mit einem ersten Funktionsbaustein zur Erzeugung von Prozessdaten für einen Aktuator oder zum Empfang von Prozessdaten eines Sensors und mit einem diesem ersten Funktionsbaustein nachgeschalteten zweiten Funktionsbaustein, welcher dazu ausgebildet ist, Prozessdaten mit einem Zeitstempel zu versehen.

Ein derartiges Automatisierungsgerät ist z. B. aus dem Siemens-Katalog "ST PCS 7, Prozessleitsystem SIMATIC PCS 7, Ausgabe 2013" bekannt. Solche Automatisierungsgeräte, welche häufig auch als speicherprogrammierbare Steuerungen (SPS) oder als "Programmable Logic Controller" (PLC) bezeichnet werden, weisen zur Verwirklichung von Automatisierungsfunktionen eine Vielzahl von Software-Funktionsbausteinen auf, die während der Steuerung eines technischen Prozesses mittels einer geeigneten CPU des Automatisierungsgerätes verarbeitet werden. Beispielsweise erzeugt ein Regler-Funktionsbaustein geeignete Prozessdaten in Form von Prozessausgangswerten bzw. Stellwerten für einen Aktuator, wobei der Regler die Stellwerte aufgrund von übermittelten Prozesseingangswerten eines Sensors und Abweichungen von vorgegebenen Sollwerten ermittelt.

Aus dem Siemens-Katalog "ST PCS 7" ist darüber hinaus bekannt, mittels geeigneten mit dem Automatisierungsgerät verbundenen Servern und mittels geeigneter Software eine Langzeitarchivierung von Prozessdaten zu bewerkstelligen. Die für eine Archivierung bestimmten Prozessdaten bzw. Prozesseingangs- und -ausgangswerte einer zu steuernden Anlage werden "eingesammelt", komprimiert und schließlich in einem Datenbanksystem archiviert. Eine derartige Langzeitarchivierung ist erforderlich, um langfristig wertvolle Informationen des zu steuernden Prozesses aus den Prozessdaten extrahieren zu können, welche beispielweise für eine Prozessoptimierung oder für Qualitätssicherungsmaßnahmen ausgewertet werden. Nachteilig ist, dass die Prozessdaten stets zyklisch über ein Netzwerk zum Server übertragen werden, wobei diese Daten auch dann übertragen werden, wenn sich diese kaum ändern. Dies bedeutet einerseits ein hohes Datenaufkommen im Server, was zu einer Überlast und zu Datenverlust führen kann, und anderseits eine hohe Kommunikationslast zwischen dem Server und den Automatisierungskomponenten.

Der Erfindung liegt daher die Aufgabe zugrunde, ein Automatisierungsgerät der eingangs genannten Art zu schaffen, welches Prozessdaten für eine Archivierung aufbereitet.

Diese Aufgabe wird durch die im kennzeichnenden Teil des Anspruchs 1 angegebenen Maßnahmen gelöst.

Die Erfindung geht von der Idee aus, die ohnehin im Automatisierungsgerät vorliegenden Prozessdaten auch dort - also im Automatisierungsgerät - für eine Archivierung geeignet aufzubereiten. Dadurch kann im Hinblick auf eine Archivierung von Prozessdaten auf einen dedizierten und leistungsstarken Server verzichtet werden, welcher gewöhnlich entsprechend projektiert, administriert und gesichert werden muss. Darüber hinaus wird der gewöhnlich im Automatisierungsgerät ohnehin hinterlegte zweite Funktionsbaustein, ein so genannter "Event Driven Communication"-Baustein, in geeigneter Weise für die Aufbereitung der Daten genutzt. Dieser Baustein zeichnet sich dadurch aus, dass dieser Prozessdaten nicht zyklisch übermittelt bzw. überträgt, sondern nur dann, falls die Prozessdaten sich geändert haben.

In einer Ausgestaltung der Erfindung ist der dritte Funktionsbaustein dazu ausgebildet, zur Codierung sowohl der Prozessdaten- als auch der Zeitstempel-Differenzen, welche jeweils 2^{m} Byte umfassen, jeweils eine Codierungslänge von m-Bit vorzusehen, wobei m=1, 2, 3 ... ist. Mittels derartiger Maßnahmen wird in einfacher Weise das Datenaufkommen stark vermindert.

Anhand der Zeichnung, in der ein Ausführungsbeispiel der Erfindung veranschaulicht ist, werden im Folgenden die Erfindung, deren Ausgestaltungen sowie Vorteile näher erläutert.

Es zeigen in einer vereinfachten Darstellung
- Figur 1: ein Blockschaltbild von Komponenten eines Automatisierungsgerätes,
- Figur 2: einen Funktionsbaustein,
- Figur 3: Datenpakete und
- Figur 4: einen Datenstrom.

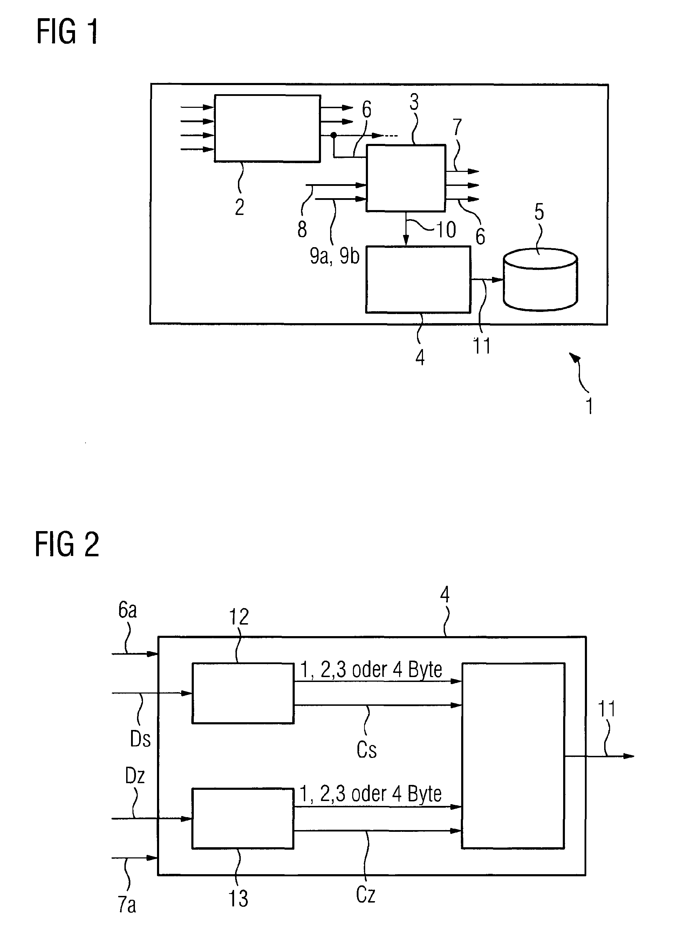

Die in den Figuren 1 bis 4 dargestellten gleichen Teile sind mit gleichen Bezugszeichen versehen.

In Figur 1 ist mit 1 ein Automatisierungsgerät 1 bezeichnet, das gewöhnlich zur Verwirklichung von Automatisierungsfunktionen eine Vielzahl von Software-Funktionsbausteinen aufweist, die während der Steuerung eines technischen Prozesses mittels einer geeigneten hier nicht dargestellten CPU des Automatisierungsgerätes verarbeitet werden. Selbstverständlich weist das Automatisierungsgerät 1 zur Steuerung des technischen Prozesses ebenfalls eine Vielzahl von geeigneten Hardware-Komponenten auf, z. B. Analog- oder Digitalein-/ -ausgabebaugruppen, Kommunikationsbaugruppen oder sonstige geeignete Funktionsbaugruppen.

Im vorliegenden Ausführungsbeispiel ist das Automatisierungsgerät 1 mit drei Software-Funktionsbausteinen versehen, von denen ein erster Funktionsbaustein 2 als ein Regler-Baustein und ein zweiter Funktionsbaustein 3 als ein so genannter "Event Driven Communication"-Baustein - im Folgenden als EDC-Baustein bezeichnet - ausgebildet sind. Ein dritter Funktionsbaustein 4 ist zur Erzeugung eines kontinuierlichen Datenstroms vorgesehen, welcher - wie im Folgenden noch gezeigt wird - einen komprimierten Datenstrom 11 repräsentiert, der in einem Umlaufspeicher 5 des Automatisierungsgeräts 1 hinterlegt wird.

Aus vorgegebenen Sollwerten und Prozesseingangsdaten - bzw. Prozessdaten in Form von Istwerten - eines Sensors erzeugt der Regler-Baustein 2 Prozessdaten - bzw. Prozessausgangsdaten in Form eines Stellwertes 6 - für einen an eine hier nicht dargestellte Ausgabebaugruppe des Automatisierungsgerätes 1 angeschlossenen Aktuator, wobei der Regler-Baustein 2 diesen Stellwert 6 dem EDC-Baustein 3 zuführt. Der EDC-Baustein 3 ist derart ausgebildet, dass dieser EDC-Baustein 3 den Stellwert 6 nur dann dem Aktuator übermittelt bzw. überträgt, falls sich der Stellwert 6 geändert hat, wobei bei einer Änderung des Stellwerts 6 der EDC-Baustein 3 diesem Stellwert 6 einen Zeitstempel 7 zuordnet bzw. zuweist, welcher den Zeitpunkt der Änderung repräsentiert. Dies bedeutet im Gegensatz zu einer zyklischen Stellwert-Übertragung eine geringere Kommunikationsbelastung sowie ein vermindertes zu verarbeitendes Datenaufkommen. Der EDC-Baustein 3 ist ferner dazu ausgebildet den Stellwert 6 erst dann zu übertragen, falls eine Änderung des Stellwerts 6 seit der letzten Übertragung einen Differenz-Schwellwert 8 erreicht oder überschreitet oder falls eine maximale Zykluslänge 9a seit der letzten Übertragung überschritten wurde. Um ein hohes, beispielsweise durch Rauschen verursachtes, Datenaufkommen zu vermeiden, ist darüber hinaus eine minimale Zykluslänge 9b vorgegeben, die als Kehrwert die maximale Frequenz des Ereignisses definiert.

Im Folgenden wird die Aufbereitung der Stellwerte und der Zeitstempel für eine Archivierung näher erläutert, wobei davon ausgegangen wird, dass während der Prozesssteuerung zu einem vorgegebenen ersten Zeitpunkt ein erster Stellwert 6a (Figur 2) und zu weiteren auf den ersten Zeitpunkt folgenden zweiten, dritten, ... (n+1)-ten Zeitpunkten sich der jeweilige zweite, dritte, ... Stellwert ändert. Der EDC-Baustein 3 übermittelt dem dritten Baustein 4 über eine Verbindung 10
- zum ersten Zeitpunkt den ersten Stellwert 6a mit dazugehörigem Zeitstempel 7a, wobei dieser Zeitstempel 7a den ersten Zeitpunkt repräsentiert,
- zum zweiten Zeitpunkt eine erste Stellwert-Differenz zwischen dem zweiten Stellwert und dem ersten Stellwert 6a sowie eine erste Zeitstempel-Differenz zwischen dem (den zweiten Zeitpunkt repräsentierenden) zweiten Zeitstempel und dem ersten Zeitstempel 7a,
- zum dritten Zeitpunkt eine zweite Stellwert-Differenz zwischen dem dritten Stellwert und dem zweiten Stellwert sowie eine zweite Zeitstempel-Differenz zwischen dem (den dritten Zeitpunkt repräsentierenden) dritten Zeitstempel und dem zweiten Zeitstempel,
- zum (n+1)-ten Zeitpunkt die n-te Stellwert-Differenz zwischen dem (n+1)-ten Stellwert und dem n-ten Stellwert sowie die n-te Zeitstempel-Differenz zwischen dem (n+1)-ten Zeitstempel und dem n-ten Zeitstempel.

Aus dem ersten Stellwert 6a und dazugehörigem ersten Zeitstempel 7a sowie aus den Stellwert-Differenzen und dazugehörigen Zeitstempel-Differenzen erzeugt der dritte Baustein 4 den komprimierten Datenstrom 11, welcher der dritte Baustein 4 dem Umlaufspeicher 5 zuführt. Zur näheren Erläuterung wird dazu im Folgenden auf Figur 2 verwiesen, in welcher der dritte Baustein 4 dargestellt ist, wobei dort die Stellwert-Differenzen mit Ds und die Zeitstempel-Differenzen mit Zd bezeichnet sind und wobei sowohl die Stellwert- als auch die Zeitwert-Differenzen jeweils 32 Bit aufweisen.

Eine erste Software-Routine 12 des dritten Bausteins 4 codiert die Stellwert-Differenzen Ds, indem die Software-Routine 12 zwei Bit zur Codierung einer Codierungslänge Cs vorsieht, um die jeweilige Stellwert-Differenz mit 1, 2, 3 oder 4 Byte zu codieren. In der entsprechenden Art und Weise codiert eine zweite Software-Routine 13 die Zeitstempel-Differenzen Zd. Auch im Hinblick auf diese Differenzen sind zwei Bit zur Codierung einer Codierungslänge Cz vorgesehen, um die jeweilige Zeitstempel-Differenz mit 1, 2, 3 oder 4 Byte zu codieren. Allgemein ist zur Codierung sowohl der Stellwertals auch der Zeitstempel-Differenzen, welche jeweils 2^{m} Byte umfassen, jeweils eine Codierungslänge von m-Bit vorzusehen, wobei m=1, 2, 3 ... ist.

Mittels einer derartigen Codierung werden im Hinblick auf eine Datenkomprimierung im günstigsten Fall für die Codierung sowohl einer Stellwert-Differenz als auch einer Zeitstempel-Differenz lediglich 10 Bit benötigt. Dies ist dann der Fall, falls der Betrag der jeweiligen Differenz sehr gering ist und daher für deren Codierung lediglich ein Byte erforderlich ist.

Im ungünstigsten Fall - falls der Betrag der jeweiligen Differenz sehr hoch ist und daher für die jeweilige Codierung vier Bytes benötigt werden - werden jeweils 32 Bit benötigt, was bedeutet, dass ein derartig "komprimiertes" Datenpaket um 4 Bit größer ist als ein nicht komprimiertes Datenpaket.

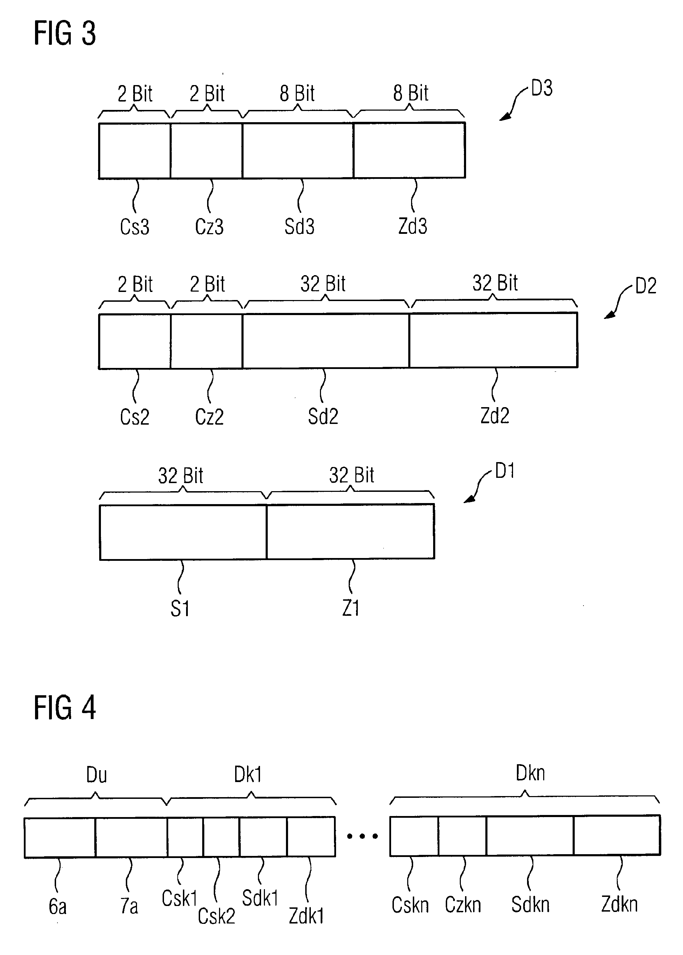

Figur 3 zeigt ein nicht komprimiertes Datenpaket D1 und zwei "komprimierte" Datenpakete D2, D3. Das Datenpaket D3 umfasst 2 Bit zur Codierung einer Codierungslänge Cs3 einer Stellwert-Differenz Sd3, 2 Bit zur Codierung einer Codierungslänge Cz3 einer Zeitstempel-Differenz Zd3 und jeweils 8 Bit für die Stellwert- und Zeitstempel-Differenz Sd3, Zd3. Das derart codierte Datenpaket D3 umfasst daher 20 Bit. Im Vergleich zum nicht komprimierten Datenpaket D1, welches jeweils 32 Bit für einen Stellwert S3 und einen Zeitstempel Z3 umfasst, ist das Datenpaket D3 um 44 Bit reduziert. Das "komprimierte" Datenpaket D2 (Cs2, Cs2, Sd2, Zd2)dagegen umfasst 68 Bit und benötigt daher 4 Bit mehr als das nicht komprimierte Datenpaket D3.

Aufgrund dessen, dass Differenzen von Stellwerten sowie Zeitstempeln gewöhnlich einen kleineren Wertebereich aufweisen als diese Stellwerte bzw. Zeitstempel selbst, werden die Längen der Datenpakete und dadurch die Länge des aus diesen Datenpaketen erzeugten Datenstroms 11 erheblich vermindert. Dieser Datenstrom 11 umfasst den zum ersten Zeitpunkt übermittelten ersten Stellwert 6a mit dazugehörigem Zeitstempel 7a (in Figur 4 als Datenpaket Du bezeichnet) und eine Vielzahl von komprimierten Datenpaketen Dk1, Dk2, ... Dkn, welche jeweils die Codierung der Codierungslängen Ck1, Ck2, ... Ck2 und Stellwert- und Zeitstempeldifferenzen Sdk1, Sdk2, ... Sdkn, Zdk1, Zdk2, ... Zdkn umfassen. In einem praktischen Ausführungsbeispiel der Erfindung wird aufgrund der beschriebenen "dynamischen Datenkompression" eine Kompressionsrate von ca. 55% erzielt. Der dritte Baustein 4 hinterlegt diesen Datenstrom 11 in den Umlaufspeicher 5, wobei die Daten dieses Umlaufspeichers 5 zu einem geeigneten Zeitpunkt z. B. in einen Speicher einer Maintenance-Station transferiert werden können.

## Patentansprüche

1. Automatisierungsgerät mit
- einem ersten Funktionsbaustein (2) zur Erzeugung von Prozessdaten (6) für einen Aktuator oder zum Empfang von Prozessdaten eines Sensors und
- einem diesem ersten Funktionsbaustein (2) nachgeschalteten zweiten Funktionsbaustein (3), welcher dazu ausgebildet ist, Prozessdaten (6) mit einem Zeitstempel (7) zu versehen,
**dadurch gekennzeichnet, dass**
- der zweite Funktionsbaustein (3) ferner dazu ausgebildet ist, einem dritten Funktionsbaustein (4)
- zu einem ersten Zeitpunkt erste Prozessdaten (6a) und einen diesen Prozessdaten (6a) zugehörigen ersten Zeitstempel (7a), und
- zu auf den ersten Zeitpunkt folgenden Zeitpunkten Differenzen (Ds) zwischen (n+1)-ten Prozessdaten und n-ten Prozessdaten sowie Differenzen (Dz) zwischen diesen Prozessdaten zugehörigen (n+1)-ten Zeitstempeln und n-ten Zeitstempeln
zu übermitteln, wobei n=1, 2, 3, ... ist, und
- der dritte Funktionsbaustein (4) dazu ausgebildet ist, aus den ersten Prozessdaten (6a), dem ersten Zeitstempel (7a) und den Prozessdaten- und Zeitstempel-Differenzen (Ds, Dz) einen codierten Datenstrom (11) zu erzeugen.

2. Automatisierungsgerät nach Anspruch 1, **dadurch gekennzeichnet, dass** der dritte Funktionsbaustein (4) dazu ausgebildet ist, zur Codierung sowohl der Prozessdaten- als auch der Zeitstempel-Differenzen (Ds, Dz), welche jeweils 2^{m} Byte umfassen, jeweils eine Codierungslänge von m-Bit vorzusehen, wobei m=1, 2, 3 ... ist.
